Europäisches Patentamt

European Patent Office

Office européen des brevets

(11) Publication number: **0 196 897 B1**

# EUROPEAN PATENT SPECIFICATION

(45) Date of publication of patent specification: **22.01.92**

(51) Int. Cl.⁵: **H01L 21/324**, H01L 21/302, C30B 23/02

(21) Application number: **86302355.2**

(22) Date of filing: **27.03.86**

(54) Thermal etching of a compound semiconductor.

(30) Priority: **02.04.85 JP 68460/85**

(43) Date of publication of application:
**08.10.86 Bulletin 86/41**

(45) Publication of the grant of the patent:
**22.01.92 Bulletin 92/04**

(84) Designated Contracting States:
**DE FR GB**

(56) References cited:
**EP-A- 0 113 983**
**US-A- 3 992 233**
**US-A- 4 493 142**

**JOURNAL OF THE ELECTROCHEMICAL SOCIETY, vol. 131, no. 9, September 1984, pages 2115-2117, Manchester, New Hampshire, US; F. AURET "Thermal cleaning of InSb surfaces in an ultrahigh vacuum"**

**JAPANESE JOURNAL OF APPLIED PHYSICS. SUPPLEMENTS 16th INTERNATIONAL CONFERENCE SOLID STATE DEVICES AND MATERIALS, 30th August - 1st September 1984, pages 56-57, Tokyo, JP; N. MATSUO et al.:**

**"Self-cleaning by silicon beam in molecular beam epitaxy"**

(73) Proprietor: **FUJITSU LIMITED**
**1015, Kamikodanaka Nakahara-ku**
**Kawasaki-shi Kanagawa 211(JP)**

(72) Inventor: **Saito, Junji**
**22-15-409, Sakuradai 1-chome**
**Isehara-shi Kanagawa 259-11(JP)**

(74) Representative: **Rackham, Stephen Neil et al**
**GILL JENNINGS & EVERY 53-64 Chancery Lane**
**London WC2A 1HN(GB)**

## Description

The present invention relates to a process for carrying out a thermal-etching treatment of a GaAs semiconductor substrate to be used in molecular beam epitaxy. More particularly, it relates to a process for the thermal removal of surface carbon, carbide or other carbon compounds from a substrate.

A molecular beam epitaxy (MBE) technique with compound semiconductors such as GaAs is often used for the fabrication of high speed devices such as high electron mobility transistors (HEMT), and it is well known that a carrier depletion layer is formed around an interrupted growth interface and a substrate epitaxial interface. Such a depletion layer sometimes degrades the performance of the devices.

Therefore, cleaning of the substrate in the MBE chamber prior to the epitaxial growth process is very important to an improvement of the quality of the epitaxial films. The major contaminations on a GaAs substrate after chemical etching and loading in to an MBE chamber are oxygen and carbon from carbon dioxide ($CO_2$) or hydrocarbons. This is discussed in an article entitled "Interface and doping profile characteristics with molecular-beam epitaxy of GaAs:GaAs voltage varactor", which appeared in J. Appl. Phys. 45(4) April, 1974. Oxygen can be thermally removed by heating the substrates to about 530°C. However, this does not remove other contamination especially carbon, carbides or other carbon compounds from GaAs substrate.

Further, when a semiconductor crystalline layer is epitaxially formed on a surface of a GaAs substrate in a state wherein carbon atoms, and other contamination is present the carbon and other contamination act as acceptors so that an interfacial level between the GaAs substrate and the semiconductor crystalline layer is formed. To avoid the effect of the formation of the interfacial level, the formation of thick buffer layer is necessary. This takes a long time and thus throughput decreases.

US-A-3992233 describes a process for thermal-etching treatment of a GaAs substrate comprising heating the GaAs substrate in a treatment chamber whilst irradiating a surface of the GaAs substrate with an As molecular beam to remove contamination adhering to the GaAs substrate by evaporating a part of it and then subjecting the substrate to further processing steps without it leaving the treatment chamber. In this example the further processing that takes place is the deposition of alternate monologues of caesium and oxygen to form a photocathode. The substrate must be heated to a temperature above 620°C and in the particular example is heated to a temperature of 700°C.

According to this invention such a process is characterised in that the substrate is heated to a temperature higher than 750°C, at which temperature both Ga and As evaporate from the GaAs substrate, and in that the further processing steps consist of epitaxial growth by molecular beam epitaxy on the cleaned surface of the substrate.

The present invention provides a process for thermal-etching treatment of a GaAs substrate for use in molecular beam epitaxy wherein carbon is thermally removed and the surface defect density between the substrate and an epitaxial layer is removed.

An advantage of the present invention is that it enables only a thin buffer layer to be provided on which a semiconductor crystalline layer having good properties and less defects is subsequently formed and this increases production throughput.

A particular example of the present invention will now be described with reference to the accompanying drawings; in which:-

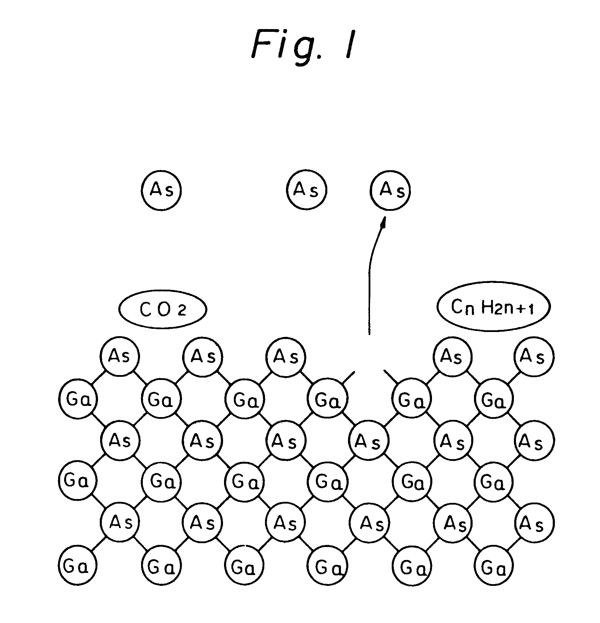

Figure 1 is a diagram illustrating evaporation As from surface of a GaAs compound;

Figure 2 is a graph showing the dependence of the thermal etching rate on the substrate temperature at an $As_4$ pressure;

Figure 3 is a graph showing the dependence of the amount of the carrier depletion on the etching depth;

Figure 4 is a graph showing the dependence of the carbon concentration on the depth removed by the thermal etching at 720°C and 750°C;

Figure 5 is a diagram illustrating how the surface contamination is removed by evaporating a part of the GaAs surface;

Figure 6 is a diagram of apparatus suitable for the process;

Figure 7 is a cross-section through a wafer produced by the present invention; and,

Figure 8 is a graph showing the mobility and sheet concentration of a two dimensional electron gas (2DEG) as a function of the thickness of a GaAs buffer layer.

In order to find the dependence of the thermal etching rate on a GaAs substrate with the arsenic pressure, the present inventor experimented as follows.

The (100)GaAs substrate was degreased in trichloroethylene, and rinsed in sequence with methanol and deionized water. The substrate was then chemically etched in $H_2SO_4:H_2O:H_2O_2$, rinsed with deionized water, dried with dry nitrogen gas, and mounted on an Mo block using solder. The thermal etching was carried out in the growth chamber at a substrate temperature of 720°C, 750°C, and 780°C with an $As_4$ pressure of $2 \times 10^{-3}$Pa ($1.5 \times 10^{-5}$ Torr). The substrate temperature was measured by a calibrated infrared pyrometer.

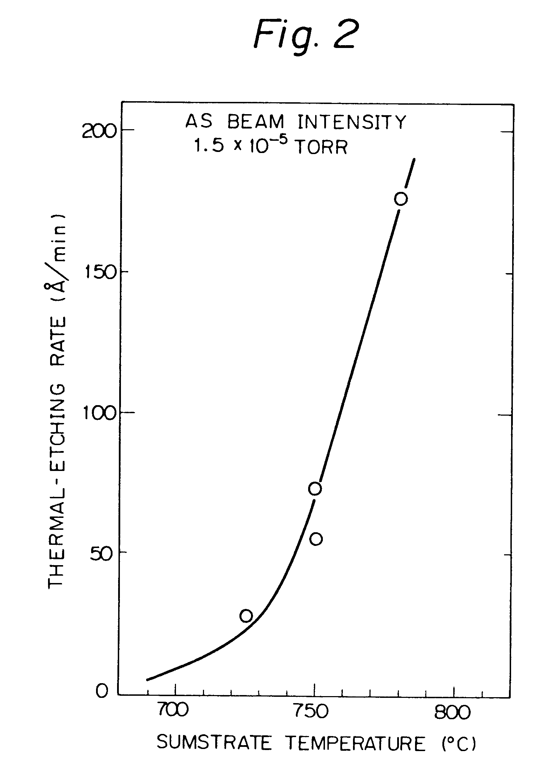

As shown in Figure 2, the etching rates were remarkably increased in accordance with the substrate temperature; i.e., approximately 2 nm/min (20Å/min) at 720°C, 6nm/min (60Å/min) at 750°C, and 18nm/min (180Å/min) at 780°C, with an $As_4$ pressure of $2\times10^{-3}$Pa ($1.5 \times 10^{-5}$) Torr. It can be seen that the etching rate remarkably increases at a temperature above 750°C. The inventor also found that the increment of the etching rate as a function of the temperature is almost the same as the vapour pressure of the Ga.

The present inventor then studied the dependence of the carrier depletion on the etching depth.

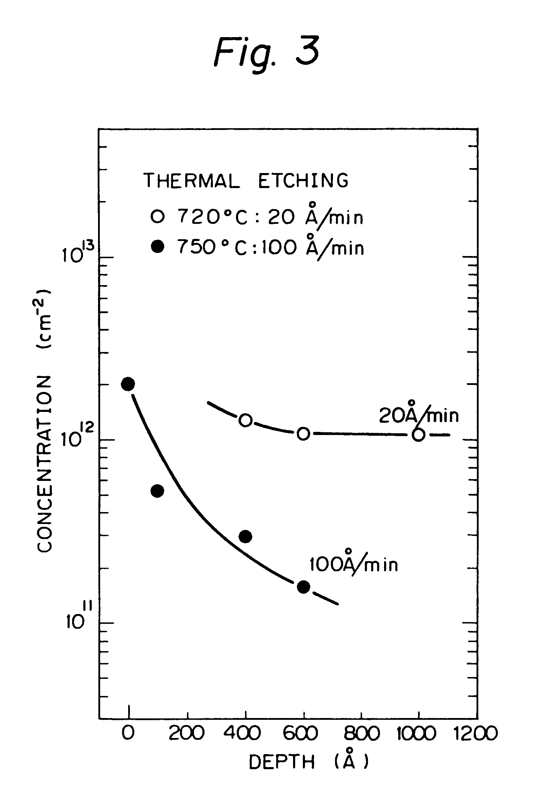

Si doped n-GaAs layer was grown on an Si doped GaAs substrate at a rate of 1 $\mu$m/h at a substrate temperature of 640°C. The doping levels of the epitaxial layer and the substrate were $8 \times 10^{16}$ $cm^{-3}$. The thickness of the epitaxial layer was approximately 1 $\mu$m. The depth of etching was varied from 0$\mu$m to 0.1$\mu$m (0 Å to 1000 Å) by changing the etching time at the temperatures of 720°C and 750°C. The dependence of the carrier depletion on the etching depth is also shown in Fig. 3.

The possibilities of the origin of the carrier depletion are the trap formation and the carrier compensation caused by the As evaporation loss and/or the contamination on the initial substrate surface. DLTS measurement was performed to detect deep trap levels near the thermally etched and non-etched interfaces. The total concentration of the trap levels of non-etched interfaces obtained was less than $1 \times 10^{10}$ $cm^{-2}$, which is much less than the amount of the carrier depletion ($10^{12}$ $cm^{-2}$). Therefore, the deep traps may not be the origin of the carrier depletion at the interface.

The concentration of the remaining carbon at the substrate-epitaxial layer was detected by SIMS measurement using $Cs^+$ bombardment.

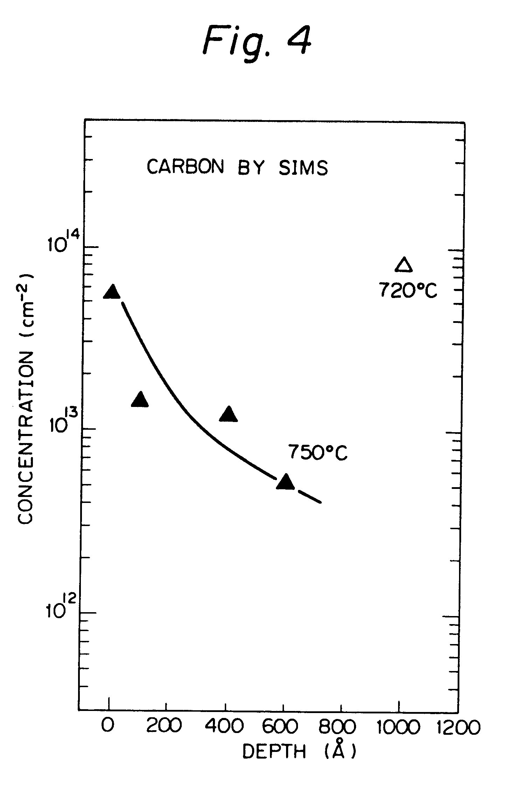

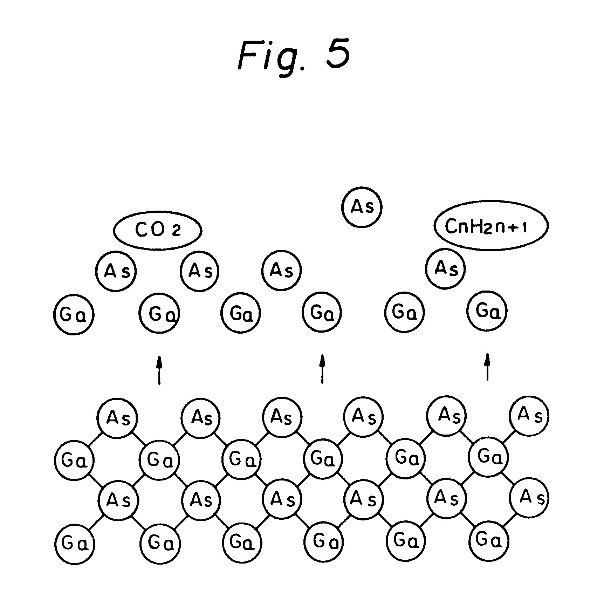

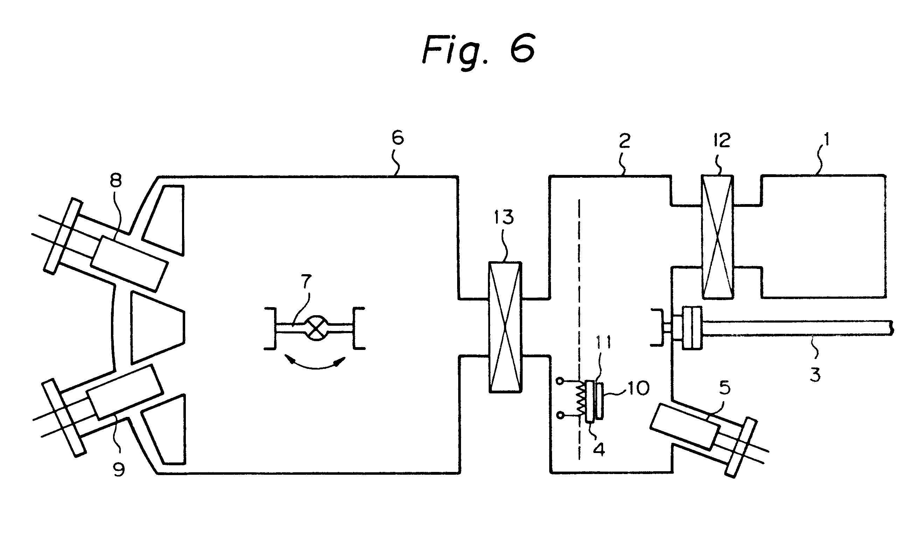

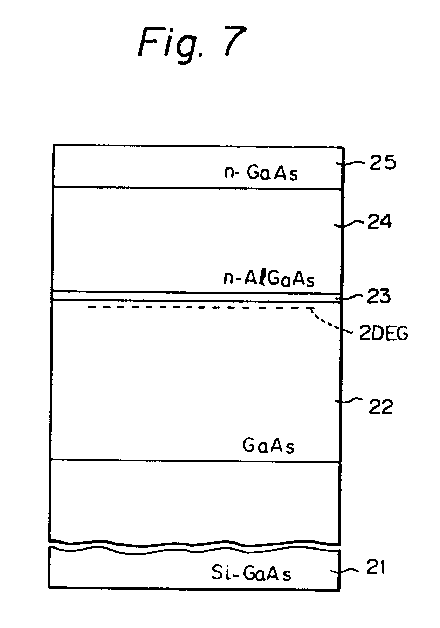

Figure 4 show the dependence of the carbon concentration on the depth removed by the thermal etching at 720°C and 750°C. The concentration of the carbon at the interface without thermal etching was $5.5 \times 10^{13}$ $cm^{-2}$. The carbon concentration was reduced to $5.3 \times 10^{12}$ $cm^{-2}$ by the etching at 750°C. On the other hand, the concentration of the carbon contamination did not depend on the etching depth in the case of a low etching temperature of 720°C. Even though the substrate was etched to 0.1$\mu$m (1,000 Å) at the temperature of 720°C, the amount of remaining carbon atoms was $8.3 \times 10^{13}$ $cm^{-2}$. The above results show that there is good correspondence between the concentration of the carbon contamination detected by the SIMS measurement (shown in Fig. 4) and the amount of the carrier depletion measured by the C-V technique (shown in Fig. 3). Therefore, the carbon contamination remaining on the substrate is considered to be the main cause of the formation of the carrier depletion. The carbon is present even though the substrate is carefully etched with $H_2SO_4$ etchant and rinsed with deionized water. Since carbon is a shallow acceptor in GaAs, it will compensate donors. When a GaAs substrate is thermally etched above 750°C, carbon ($CO_2$, $C_nH_{2n+1}$, etc.) contamination on the substrate surface may be removed by evaporating Ga and/or GaAs molecules, as shown in Fig. 5. The thermal etching technique was applied to the cleaning the GaAs substrate in the growth of selectively doped (SD) GaAs/N-$Al_{0.3}$$Ga_{0.7}$ As heterostructures of Figure 7 by using an apparatus shown in Figure 6.

In Figure 6, a GaAs substrate 10 adhered to a molybdenum (Mo) block (not shown) by an Indium (In) solder is introduced into a substrate exchanging chamber 1. Then, the chamber 1 is degassed to $1.3\times10^{-5}$Pa to $1.3\times10^{-4}$Pa ($10^{-7}$ to $10^{-8}$ Torr) and a gate valve 12 is opened. The GaAs substrate 10 is then moved to a prechamber 2, for preparing the substrate, maintained at a pressure of approximately $2.7\times10^{-7}$Pa ($2 \times 10^{-9}$ Torr) and provided with an As molecular beam source 5. When the As molecular beam is irradiated the degassed pressure in the prechamber 2 is lowered to $1.3\times10^{-5}$Pa ($10^{-7}$ Torr). The GaAs substrate 10 on a substrate holder 4, which can be heated, is heated at approximately 750°C for about 3 minutes while the As molecular beam is irradiated, in which the As pressure is $2\times10^{-3}$Pa ($1.5 \times 10$-5 Torr), and subsequently, the temperature is lowered at a rate of 20°C/min to about 300°C so that the GaAs substrate 10 can be moved to a growth chamber 6.

The reason for As molecular beam irradiation is to compensate for the eliminated arsenic atoms caused by the heat treatment 750°C or more.

In the growth chamber 6, a GaAs/AlGaAs semiconductor epitaxial layer is grown on the GaAs substrate 10 at about 680°C. Reference numerals 7, 8 and 9 denote a substrate holder, an As molecular beam source, and a Ga molecular beam source, respectively.

Figure 7 shows a cross-sectional view of an wafer produced by a process according to the present invention.

As shown in Figure 7, a 0.3 $\mu$m thick GaAs buffer layer 22 is formed on a semi-insulating GaAs substrate 21. Then, a 6nm (60 Å) thick $Al_{0.3}$ $Ga_{0.7}$ As spacer layer 23 is formed on the GaAs buffer layer 22, and subsequently, a 90nm (900Å) Si-doped ($1 \times 10^{-18}$ $cm^{-3}$) n - type $Al_{0.3}$ $Ga_{0.7}$ As electron carrier layer 24 and a 20nm (200 Å) Si-doped ($1 \times 10^{18}$ $cm^{-3}$) n-type GaAs electrode contact layer 25 are formed on the spacer layer 23.

Another example of the embodiment in the thermal etching of the present invention is that the GaAs substrate 10 is heated at 780° C for about 1.5 minutes under $2\times10^{-3}$Pa ($1.5 \times 10^{-5}$) Torr As pressure. Furthermore, another example is that the GaAs substrate 10 is heated at 770° C for about 9 minutes under $6.7\times10^{-3}$Pa ($5 \times 10^{-5}$ Torr) As pressure.

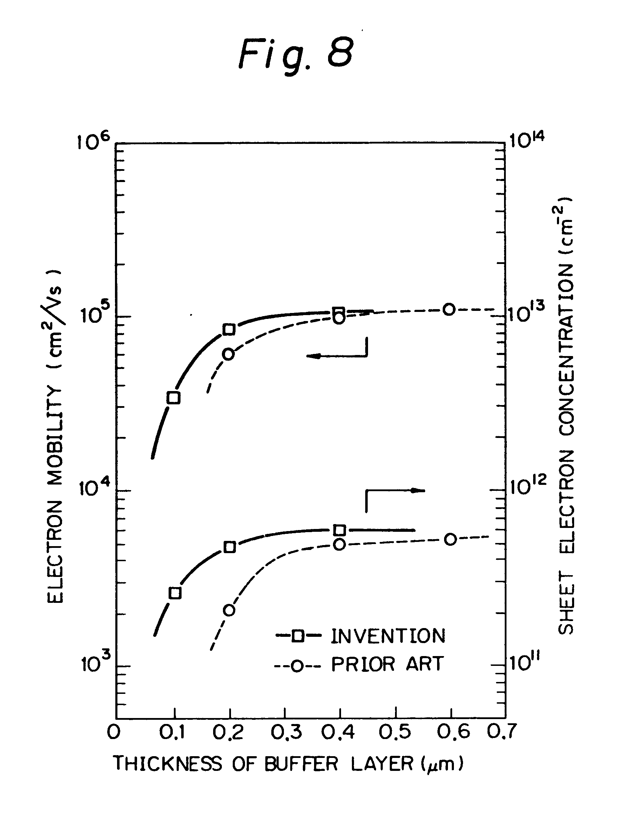

Figure 8 is a graph showing the mobility ($\mu$) and sheet concentration ($n_s$) of two dimensional electron gas (2 DEG) obtained by Hall measurements at 77k as a function of the thickness of the GaAs buffer layer. The two dimensional electron gases (2 DEG) is generated at the interface between the GaAs buffer layer 22 and the AlGaAs spacer layer 23. Moreover, the mobility ($\mu$) and the sheet concentration ($n_s$) of 2 DEG of the sample grown on a non-etched substrate provided with a 0.6 $\mu$m GaAs buffer layer produced by a conventional process are also shown in Figure 8 (open circles). As the thickness of the GaAs buffer layer decreased to less than 0.1 $\mu$m, the quality of the 2 DEG was extremely degraded for the thermally etched (present invention) and the non-etched (conventional process) substrate. For a buffer layer in the range of from 0.1 $\mu$m to 0.4 $\mu$m, however, it is clear that the thermal etching of the substrate improved the quality of the 2 DEG in SD heterostructures. The mobility and the sheet concentration of the 2 DEG with the GaAs buffer layer having a thickness of 0.2 $\mu$m grown on the thermally etched substrate according to the present invention were 90,000 cm$^2$/Vs and $5.0 \times 10^{11}$ cm$^{-2}$ at 77k. On the other hand, the values of the 2 DEG grown on the non-etched substrate according to a conventional process were approximately 60,000 cm$^2$/Vs and $4.0 \times 10^{11}$ cm$^{-2}$ at 77k. The main cause of the reduction of the 2 DEG with a thin buffer layer from 0.1 to 0.4 $\mu$m may be the carrier depletion at the substrate-epitaxial interface. The main cause of the carrier depletion is considered to be the carbon ($CO_2$, $C_nH_{2n+1}$) contamination existing on the initial growth surface. Thus it is considered that the thermal etching process according to the present invention caused a large improvement in the quality of the 2 DEG in SD GaAs/N - Al$_{0.3}$Ga$_{0.7}$ As heterostructures with a very thin GaAs buffer layer (0.2 $\mu$m).

## Claims

1. A process for thermal-etching treatment of a GaAs substrate for use in a molecular beam epitaxy, comprising heating the GaAs substrate in a treatment chamber whilst irradiating a surface of the GaAs substrate with an As molecular beam to remove contamination adhering to the GaAs substrate by evaporating a part of it and then subjecting the substrate to further processing steps without it leaving the treatment chamber; characterised in that the substrate is heated to a temperature higher than 750° C, at which temperature both Ga and As evaporate from the GaAs substrate, and in that the further processing steps consist of epitaxial growth by molecular beam expitaxy on the cleaned surface of the substrate.

2. A process according to claim 1, wherein the As molecular beam is irradiated at an As beam intensity of $2\times10^{-3}$Pa ($1.5 \times 10^{-5}$ Torr).

3. A process according to claim 1 or 2, wherein the contamination includes carbon dioxide or carbon hydride.

4. A process according to any one of the preceding claims, wherein after removal of the contamination a thin GaAs buffer layer is formed on the substrate.

## Revendications

1. Procédé de traitement par gravure thermique d'un substrat en GaAs pour utilisation dans une épitaxie par jet moléculaire, comprenant le chauffage du substrat en GaAs dans une chambre de traitement en même temps que l'irradiation d'une surface du substrat en GaAs avec un jet moléculaire d'As afin d'ôter tout contaminant qui adhère au substrat en GaAs en évaporant une partie de celui-ci puis en soumettant le substrat à des étapes de traitement ultérieures sans qu'il ne quitte la chambre de traitement ; caractérisé en ce que le substrat est chauffé à une température supérieure à 750 ° C, température à laquelle à la fois le Ga et l'As s'évaporent du substrat en GaAs, et en ce que les étapes de traitement ultérieures consistent en une croissance épitaxiale par épitaxie par jet moléculaire sur la surface nettoyée du substrat.

2. Procédé selon la revendication 1, dans lequel le jet moléculaire d'As est irradié selon une intensité de jet d'As de $2\times10^{-3}$ Pa ($1,5\times10^{-5}$ Torr).

3. Procédé selon la revendication 1 ou 2, dans lequel le contaminant inclue du dioxyde de carbone ou de l'hydrure de carbone.

4. Procédé selon l'une quelconque des revendications précédentes, dans lequel, après enlèvement du contaminant, une mince couche tampon en GaAs est formée sur le substrat.

**Patentansprüche**

1. Verfahren zur thermischen Ätzbehandlung von einem GaAs-Substrat zur Verwendung in einer Molekularstrahlepitaxie, mit Erhitzen des GaAs-Substrats in einer Behandlungskammer, während eine Oberfläche des GaAs-Substrats mit einem As-Molekularstrahl bestrahlt wird, um Verunreinigungen zu entfernen, die an dem GaAs-Substrat haften, durch Verdampfen eines Teils davon, und danach Unterwerfen des Substrats unter weitere Bearbeitungsschritte, ohne die Behandlungskammer zu verlassen; dadurch gekennzeichnet, daß das Substrat auf eine Temperatur höher als 750 $^\circ$C erhitzt wird, bei welcher Temperatur sowohl Ga als auch As von dem GaAs-Substrat verdampfen, und daß die weiteren Bearbeitungsschritte aus epitaktischem Wachstum durch Molekularstrahlepitaxie auf der gereinigten Oberfläche des Substrats bestehen.

2. Verfahren nach Ansprpuch 1, bei dem der As-Molekularstrahl mit einer As-Strahlintensität von $2 \times 10^{-3}$ Pa ($1,5 \times 10^5$ Torr) eingestrahlt wird.

3. Verfahren nach Anspruch 1 oder 2, bei dem die Verunreinigung Kohlendioxid oder Kohlenwasserstoffverbindungen enthält.

4. Verfahren nach einem der vorhergehenden Ansprüche, bei dem nach Entfernen der Verunreinigung eine dünne GaAs-Pufferschicht auf dem Substrat gebildet wird.

# Fig. 1

# Fig. 2

# Fig. 3

Fig. 4

# Fig. 5

Fig. 6

# Fig. 7

```
┌─────────────────────────┐
│        n- GaAs          │── 25
├─────────────────────────┤
│                         │── 24
│                         │
│        n-AlGaAs         │
├─────────────────────────┤── 23
│ - - - - - - - - - - - - │── 2DEG
│                         │
│                         │── 22
│         GaAs            │
├─────────────────────────┤
│                         │
│〰〰〰〰〰〰〰〰〰〰〰〰〰│
│        Si-GaAs          │── 21
└─────────────────────────┘
```

# Fig. 8